Europäisches Patentamt

European Patent Office

Office européen des brevets

(11) Veröffentlichungsnummer: **0 373 233**
**A1**

(12) # EUROPÄISCHE PATENTANMELDUNG

(21) Anmeldenummer: 88120734.4

(22) Anmeldetag: 12.12.88

(51) Int. Cl.⁵: **H01L 31/042, H01L 31/02, H01L 31/048**

(43) Veröffentlichungstag der Anmeldung:
**20.06.90 Patentblatt 90/25**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Stein, Karl-Ulrich, Dr.**
**Isartalstrasse 14**
**D-8025 Unterhaching(DE)**
Erfinder: **Cammerer, Fritz, Dr.**
**Delpstrasse 15**
**D-8000 München 80(DE)**

(54) **Solarzelleneinrichtung mit einer Rahmeneinrichtung.**

(57) Eine Solarzelleneinrichtung mit einer Rahmeneinrichtung soll eine einfache Stromführung von Solarstrom ermöglichen. Die Rahmeneinrichtung ist zur Führung von Strom ausgestaltet, der in der Solarzelleneinrichtung erzeugt worden ist.

EP 0 373 233 A1

FIG 1

## Solarzelleneinrichtung mit einer Rahmeneinrichtung

Die Erfindung betrifft eine Solarzelleneinrichtung mit einer Rahmeneinrichtung nach dem Oberbegriff des Anspruchs 1.

Solarzelleneinrichtungen besitzen häufig einen Rahmen, der verschiedenen Zwecken dienen kann, beispielsweise dem Kantenschutz, der mechanischen Stabilität der Solarzelleneinrichtung, dem Feuchteschutz und der örtlichen Befestigung der Solarzelleneinrichtung.

Bekannte Solarzelleneinrichtungen mit Rahmeneinrichtungen erfordern einen großen Aufwand bezüglich der Stromführung.

Der vorliegenden Erfindung liegt die Aufgabe zugrunde, eine Solarzelleneinrichtung mit einer Rahmeneinrichtung der eingangs genannten Art anzugeben, die eine einfache Führung von Strom, der in der Solarzelleneinrichtung erzeugt wird, ermöglicht.

Diese Aufgabe wird erfindungsgemäß durch eine Solarzelleneinrichtung mit einer Rahmeneinrichtung nach dem Anspruch 1 gelöst.

Ausgestaltungen und Vorteile der Erfindung sind in den Unteransprüchen, der Beschreibung und der Zeichnung dargestellt.

Querschnitte von Rahmeneinrichtungen von Solarzelleneinrichtungen können ausreichend groß ausgebildet werden und können so leicht die in der Solarzelleneinrichtung erzeugten hohen elektrischen Ströme aufnehmen.

Die Erfindung ermöglicht eine Verringerung der Verschaltungen im Inneren der Solarzelleneinrichtung.

Die Erfindung ermöglicht eine Verringerung der Feldverkabelung.

Einzelne Solarzelleneinrichtungen können direkt miteinander verschaltet werden.

Die Erfindung ermöglicht einen einfachen Aufbau von Parallel-und/oder Serienschaltungen von Solarzelleneinrichtungen.

Als Solarzelleneinrichtungen können alle Einrichtungen verwendet werden, die Solarzellen aufweisen und mit Rahmeneinrichtungen versehen werden können. Beispielsweise können alle Solarmodule verwendet werden.

Als Solarzelleneinrichtungen können beispielsweise Solarmodule verwendet werden, die in der Doppelglas-Technologie hergestellt sind. In der Doppelglas-Technologie werden solche Solarzellen zusammen mit ihrer elektrischen Beschaltung zwischen zwei Glasscheiben mit Hilfe von Kunststoff in flüssiger Form oder mit Hilfe von Thermoplast-Folienmaterial eingebettet.

Als Solarzelleneinrichtungen können auch Solarmodule verwendet werden, die in der Superstrat-Technik hergestellt worden sind. Dabei wird auf der Vorderseite eines Solarmoduls ebenfalls eine Glasscheibe zur Abdeckung verwendet, während die Rückseite des Solarmoduls aus Kunststoff-Folien, beispielsweise aus Aluminium-beschichteten Folien, aufgebaut ist. Zwischen Vorderseite und Rückseite des Solarmoduls sind wiederum die Solarzellen zusammen mit ihrer elektrischen Beschaltung mit Hilfe von Thermoplast-Folien eingebettet. Verfahren zur Herstellung von solchen Solarmodulen sind beispielsweise in den US-Patentschriften 4 067 764, 4 224 081, 4 231 807, 4 317 739, 4 433 200 und 4 401 839 angegeben.

Die Rahmung von Solarzelleneinrichtungen geschieht meist mit Profilen aus Aluminium oder Stahl, die beispielsweise mit Silikon abgedichtet sind.

Bei der Erfindung kann vorteilhafterweise ein Solarmodul verwendet werden, wie es in der US-Patentschrift 4 567 316 bzw. in der europäischen Offenlegungsschrift der Anmeldenummer 84 102 071.2 beschrieben ist. Bei diesem Solarzellenmodul sind einzelne Solarzellen in Reihen angeordnet, die wenigstens teilweise elektrisch in Serie geschaltet sind. Gegebenenfalls sind Bypassdioden parallel zu einzelnen Ketten dieser Solarzellen geschaltet, um die Heizleistung in partiell abgeschatteten Solarzellen zu begrenzen.

Diese Bypassdioden sind direkt in das Solarzellenmodul integriert, so daß allein für diese Bypassdioden ein aufwendiger Anschlußkasten nicht erforderlich ist und bei der vorliegenden Erfindung nur noch zwei Anschlüsse aus dem Solarzellenmodul herausgeführt werden müssen.

Vorteilhafterweise werden Solarzelleneinrichtungen mit Hilfe von Glasscheiben oder mit Hilfe von Glasfasern mechanisch stabilisiert und mit einer Rahmeneinrichtung zur Führung von Strom, der in der Solarzelleneinrichtung erzeugt worden ist, versehen.

Vorteilhafterweise werden bei der Erfindung Solarzelleneinrichtungen verwendet, die mit einem Minimum an elektrischer Verdrahtung auskommen. Beispielsweise können Solarzellen mit Hilfe von einem Substrat oder Superstrat mechanisch stabilisiert werden, wobei das Substrat bzw. das Superstrat elektrisch leitfähige Bereiche wie Metallisierungen oder elektrisch leitfähige Kunststoffe zur elektrischen Verbindung zwischen Solarzellen und Solarzellen bzw. Solarzellen und elektrisch leitfähiger Rahmeneinrichtung aufweisen.

Die Rahmeneinrichtungen können Strom von Solarzellenketten abnehmen. Eine Solarzelleneinrichtung kann jedoch auch eine einzelne Solarzelle aufweisen. Außerdem können die Rahmeneinrichtungen auch von mehreren Solarzellen innerhalb der Solarzelleneinrichtung Strom abnehmen.

Die Rahmeneinrichtung kann mindestens teilweise aus Metall bzw. aus einem elektrisch leitfähigen Kunststoff oder aus einer Kombination von Metall und elektrisch leitfähigem Kunststoff bestehen.

Die Rahmeneinrichtung kann mehrpolig ausgeführt werden durch eine Isolationseinrichtung, wie sie in der Fenstertechnik für die Verringerung des Wärmedurchgangs bei Metallfensterrahmen üblich sind, und die nicht nur bezüglich Wärmedurchgang, sondern auch elektrisch isoliert.

Solarzellen können direkt mit der Rahmeneinrichtung elektrisch leitend verbunden sein. Solarzellen können jedoch auch mit elektrisch leitfähigen Verbindungen, z. B. Bändchen, oder mit anderen elektrisch leitfähigen Verdrahtungen versehen werden und mit solchen Einrichtungen untereinander und/oder mit der Rahmeneinrichtung elektrisch verbunden werden.

Elektrische Verbindungen, wie sie bei einer Solarzelleneinrichtung mit einer Rahmeneinrichtung nach der Erfindung erforderlich sind, können durch Löten, Schweißen, Klemmen, durch Verwendung von elektrisch leitendem Kleber oder durch jede andere Maßnahme, die dem Fachmann bekannt ist, hergestellt werden. Für den Stromübergang zur eigentlichen Rahmeneinrichtung hin eignen sich auch leitfähige Gummimassen bzw. elektrisch leitfähige Dichtungsmassen.

Elektrische Verbindungen zwischen verschiedenen Solarzellen oder zwischen Solarzelle und Rahmeneinrichtung können durch elektrisch leitfähige Folien oder durch elektrisch leitfähige Metallisierungen oder durch elektrisch leitfähige Kunststoffbereiche auf einem Substrat (Leiterplatte) und/oder Superstrat (Glasscheibe) hergestellt werden.

Elektrische Verbindungen zwischen verschiedenen Solarzellen und/oder zwischen Solarzellen und Rahmeneinrichtung können durch Anwendung der Leiterplattentechnik hergestellt werden.

Eine Solarzelleneinrichtung mit einer Rahmeneinrichtung nach der Erfindung kann zweiseitig gerahmt sein bzw. allseitig gerahmt sein, bzw. nur an Teilen von Kanten Rahmeneinrichtungen aufweisen. Verschiedene elektrisch leitende Rahmenteile können durch elektrisch isolierende Rahmenteile getrennt sein.

Die Solarzellen innerhalb einer Solarzelleneinrichtung können parallel und/oder seriell verschaltet sein.

Die Erfindung wird im folgenden anhand der Zeichnung näher erläutert.

FIG 1 zeigt eine Solarzelleneinrichtung mit einer Rahmeneinrichtung nach der Erfindung.

FIG 2 erläutert die direkte elektrische Verbindung von Solarzellen.

FIG 3 zeigt eine weitere Solarzelleneinrichtung mit Rahmeneinrichtung nach der Erfindung.

FIG 4 bis 7 erläutern Einzelheiten der Erfindung.

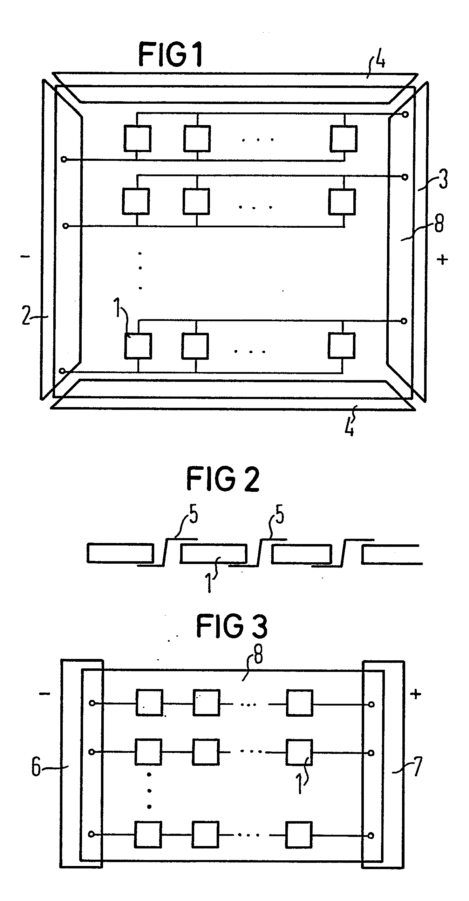

FIG 1 zeigt eine Solarzelleneinrichtung mit Solarzellen 1. Die Rahmenteile 2, 3 sind elektrisch leitfähig, die Rahmenteile 4 sind zumindest elektrisch von den Rahmenteilen 2, 3 isoliert. Die Rahmenteile 4 können darüber hinaus auch zur elektrischen Isolation zwischen den Rahmenteilen 2 und 3 dienen. Die Solarzellen 1 und die Rahmenteile 2, 3 sind so miteinander verschaltet, daß alle Solarzellen parallel zueinander geschaltet sind und daß das Rahmenteil 2 den Minuspol der gesamten Solarzelleneinrichtung und das Rahmenteil 3 den Pluspol der gesamten Solarzelleneinrichtung bildet.

Die Solarzellen 1 können dabei mit Hilfe von zusätzlicher elektrischer Verdrahtung miteinander elektrisch verbunden sein. Die Solarzellen 1 können jedoch auch durch elektrisch leitfähige Bereiche auf Substrat und/oder Superstrat direkt miteinander verbunden sein. Die Solarzellen 1 können Rand an Rand angeordnet sein.

FIG 2 zeigt Solarzellen 1, die mit Hilfe von elektrisch leitenden Einrichtungen 5, beispielsweise Bändchen, miteinander in Serie elektrisch verbunden sind.

FIG 3 zeigt eine Solarzelleneinrichtung mit Rahmenteilen 6, bei der Solarzellen 1 reihenweise in Serie verschaltet sind. Verschiedene Reihen dieser seriell verschalteten Solarzellen 1 sind dabei parallel geschaltet. Die Solarzelleneinrichtung nach FIG 3 besitzt nur zwei Rahmenteile 6, 7. Das Rahmenteil 6 bildet dabei den Minuspol, das Rahmenteil 7 den Pluspol.

Als Rahmenteile können bei der Erfindung Profilteile verwendet werden, die als Stranggußteile oder Strangpressteile hergestellt werden können.

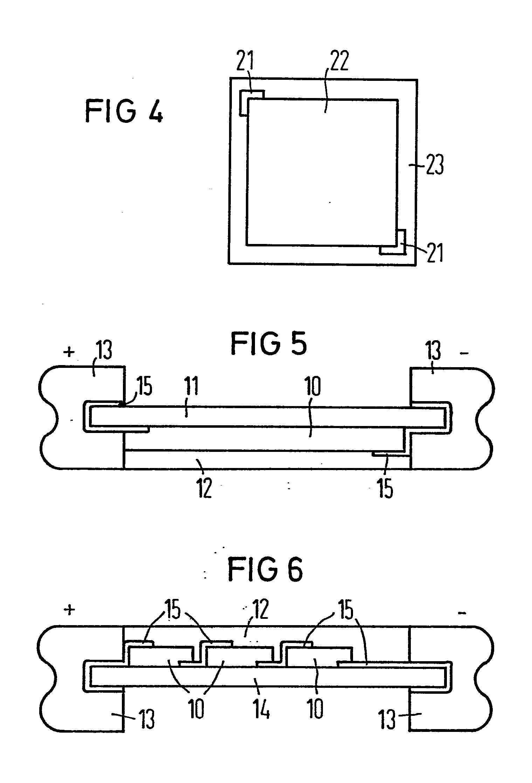

FIG 4 zeigt eine Draufsicht auf ein Solarmodul ohne Rahmeneinrichtung, das für die Erfindung verwendbar ist. Die in der FIG 4 nicht dargestellten Solarzellen sind mit einer Thermoplast-Folie 22 bedeckt. Das Solarmodul 19 besitzt eine Glasscheibe 23 als Superstrat. Die elektrische Verbindung zwischen den Solarzellen des Solarmoduls 19 und der gemäß der Erfindung anzubringenden Rahmeneinrichtung wird durch metallisierte Flächen 21 auf dem Glas 23 erzielt.

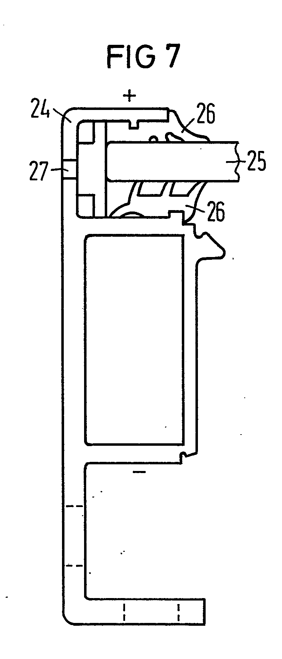

FIG 5 und 6 zeigen Solarzelleneinrichtungen nach der Erfindung im Schnitt. In FIG 7 ist eine einzige Solarzelle 10 gezeigt. Als Superstrat ist eine Glasscheibe 11 verwendet. Die Glasscheibe 11 zusammen mit der Solarzelle 10 ist dabei mit zwei Rahmenteilen 13 versehen. Die beiden Rahmenteile 13 sind elastisch auf die Glasscheibe 11 gedrückt oder auf die Glasscheibe 11 aufgesetzt und verschraubt. Die Rahmenteile können auch aus elektrisch leitfähigem Kunststoff bestehen. Die Rahmenteile 13 sind über elektrische Verbindungen 15 direkt mit der Solarzelle 10 elektrisch verbunden. Die elektrischen Verbindungen 15 können elektrisch leitfähige Folien oder elektrisch leitfähige Metalli sierungen oder elektrisch leitfähige Kunststoffbereiche sein. FIG 6 zeigt ein Solarmodul, das ähnlich wie die Solarzelleneinrichtung nach FIG 5 aufgebaut ist. Das Solarmodul nach FIG 6 besitzt mehrere Solarzellen 10. Anstelle der Glasscheibe 11 ist in FIG 6 ein Substrat 14 (Leiterplatte) vorgesehen. Die Solarzellen 10 in FIG 5 und 6 können mit Kunststoff 12 bedeckt sein.

Bei einer Solarzelleneinrichtung nach der Erfindung kann vorteilhafterweise auf eine sogenannte Anschlußbox verzichtet werden. Bypassdioden können direkt in die Solarzelleneinrichtung integriert werden.

Bypassdioden können jedoch auch in die Rahmeneinrichtung integriert werden.

Solarzelleneinrichtungen nach der Erfindung besitzen vorteilhafterweise als Substrat und/oder Superstrat eine Glasscheibe 8.

Die Rahmeneinrichtung zur Stromführung kann auch aus mehreren bis vielen stromführenden Rahmenteilen bestehen.

Zur Herstellung der Rahmeneinrichtung kann die Berandung der Solarzelleneinrichtung ganz oder teilweise mit Kunststoff umpreßt werden. Dieser Kunststoff kann dabei zumindest teilweise elektrisch leitfähig ausgestaltet werden.

Zur Herstellung der Rahmeneinrichtung kann zumindest abschnittsweise auch ein bei Solarzelleneinrichtungen bekanntes metallisches Rahmenprofil verwendet werden, das gegebenenfalls zusätzlich auch noch mit einer elektrischen Isolation versehen wird.

FIG 7 zeigt ein bekanntes metallisches Rahmenprofil 24, das zur zumindest teilweisen Rahmung eines Glas-Kunststoffverbunds 25 mit Solarzelleneinrichtungen verwendet wird. Der elektrische Kontakt zwischen Rahmeneinrichtung 24 und Solarzelleneinrichtung 25 wird durch elektrisch leitfähige Gummi- bzw. Kunststoff-Dichtungen 26 hergestellt. Die Dichtungen 26 müssen nicht notwendig leitfähig sein. Die Dichtungen 26 können dann jedoch elektrisch leitfähige Kontakteinrichtungen aufweisen.

Der elektrisch leitfähige Rahmen kann stranggepresst sein. Vorzugsweise besteht der Rahmen 24 aus Aluminium. Der Rahmen 24 kann eine elektrische Isolation 27 aufweisen. Dann kann sich der Pluspol im oberen Teil des Rahmens 24 und der Minuspol im unteren Teil des Rahmens 24 befinden.

## Ansprüche

1. Solarzelleneinrichtung mit einer Rahmeneinrichtung, **gekennzeichnet durch** Ausgestaltung der Rahmeneinrichtung zur Führung von Strom, der in der Solarzelleneinrichtung erzeugt worden ist.

2. Solarzelleneinrichtung nach Anspruch 1, **dadurch gekennzeichnet,** daß mindestens Teile der Rahmeneinrichtung aus elektrisch leitfähigem Kunststoff oder Metall bestehen.

3. Solarzelleneinrichtung nach Anspruch 1 oder 2, **gekennzeichnet durch** mehrpolige Ausführung der Rahmeneinrichtung.

4. Solarzelleneinrichtung nach einem der Ansprüche 1 bis 3, **gekennzeichnet durch** direkte elektrische Verbindung wenigstens einer Solarzelle mit der Rahmeneinrichtung.

5. Solarzelleneinrichtung nach einem der Ansprüche 1 bis 4, **gekennzeichnet durch** elektrische Verbindung wenigstens einer Solarzelle mit der Rahmeneinrichtung mit Hilfe von Bändchen.

6. Solarzelleneinrichtung nach einem der Ansprüche 1 bis 5, **gekennzeichnet durch** Aufbringen von elektrisch leitfähigem Material auf ein Superstrat zur elektrischen Verbindung von Solarzellen und/oder wenigstens einer Solarzelle mit der Rahmeneinrichtung.

7. Solarzelleneinrichtung nach einem der Ansprüche 1 bis 6, **gekennzeichnet durch** das Aufbringen von Solarzellen auf ein Substrat, das auf seiner Oberseite und/oder Unterseite elektrisch leitfähige Verbindungen aufweist.

88 P 1 8 0 5 E

## FIG 1

## FIG 2

## FIG 3

FIG 4

FIG 5

FIG 6

EP 0 373 233 A1

## FIG 7

+

24

26

27

25

26

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN, Band 9, Nr. 291 (E-359)[2014], 19. November 1985; & JP-A-60 130 868 (MATSUSHITA DENKI SANGYO K.K.) 12.07.1985 * Zusammenfassung * --- | 1,2,3,5,7 | H 01 L 31/042 H 01 L 31/02 H 01 L 31/048 |
| A | DE-A-3 111 969 (SIEMENS AG) * Patentansprüche; Abbildungen 1-3; Seite 5, Zeile 36 - Seite 7, Zeile 2 * --- | 1,4,7 | |
| D,A | US-A-4 401 839 (B.D. PYLE) * Das ganze Dokument * --- | 1,2,5,7 | |
| A | DE-A-3 617 675 (LICENTIA PATENT-VERWALTUNGS GmbH) * Patentansprüche * --- | 1,6,7 | |
| A | DE-A-2 942 328 (STONE-PLATT CRAWLEY LTD) --- | | |
| A | US-A-4 392 009 (J.D. NAPOLI) ----- | | |

RECHERCHIERTE SACHGEBIETE (Int. Cl.5)

H 01 L

Der vorliegende Recherchenbericht wurde für alle Patentansprüche erstellt

| Recherchenort | Abschlußdatum der Recherche | Prüfer |
|---|---|---|
| DEN HAAG | 10-08-1989 | VISENTIN A. |